Europäisches Patentamt

European Patent Office

Office européen des brevets

(19)

(11) Publication number: **0 133 968**
**B1**

(12) **EUROPEAN PATENT SPECIFICATION**

(45) Date of publication of patent specification: **07.06.89**     (51) Int. Cl.⁴: **G 01 R 19/165,** H 02 H 3/027

(21) Application number: **84108937.8**

(22) Date of filing: **27.07.84**

(54) **Solid state overcurrent detector.**

(30) Priority: **29.07.83 JP 140282/83**
**29.07.83 JP 140283/83**
**29.07.83 JP 140284/83**
**29.07.83 JP 140285/83**

(43) Date of publication of application:
**13.03.85 Bulletin 85/11**

(45) Publication of the grant of the patent:
**07.06.89 Bulletin 89/23**

(84) Designated Contracting States:
**DE FR GB IT**

(56) References cited:
**DE-A-3 215 146**
**GB-A-2 073 968**
**GB-A-2 073 970**
**GB-A-2 073 973**

(73) Proprietor: **MITSUBISHI DENKI KABUSHIKI KAISHA**
**2-3, Marunouchi 2-chome Chiyoda-ku Tokyo 100 (JP)**

(72) Inventor: **Arinobu, Ichirou c/o Fukuyama Seisakusho**
**Mitsubishi Denki K.K. 1-8, Midorimachi Fukuyama-shi Hiroshima-ken, 720 (JP)**

(74) Representative: **Kuhnen, Wacker & Partner Schneggstrasse 3-5 Postfach 1553 D-8050 Freising (DE)**

EP 0 133 968 B1

# Description

## Background of the invention

### 1. Field of the invention

The present invention relates generally to a solid state overcurrent detector for detecting overcurrent, for instance, of power line or load, thereby to monitor, and further, be applied to protection of AC power lines, and more particularly concerns an overcurrent detector and a circuit interrupter suitable for most appropriate protection of AC power lines.

### 2. Background of the invention

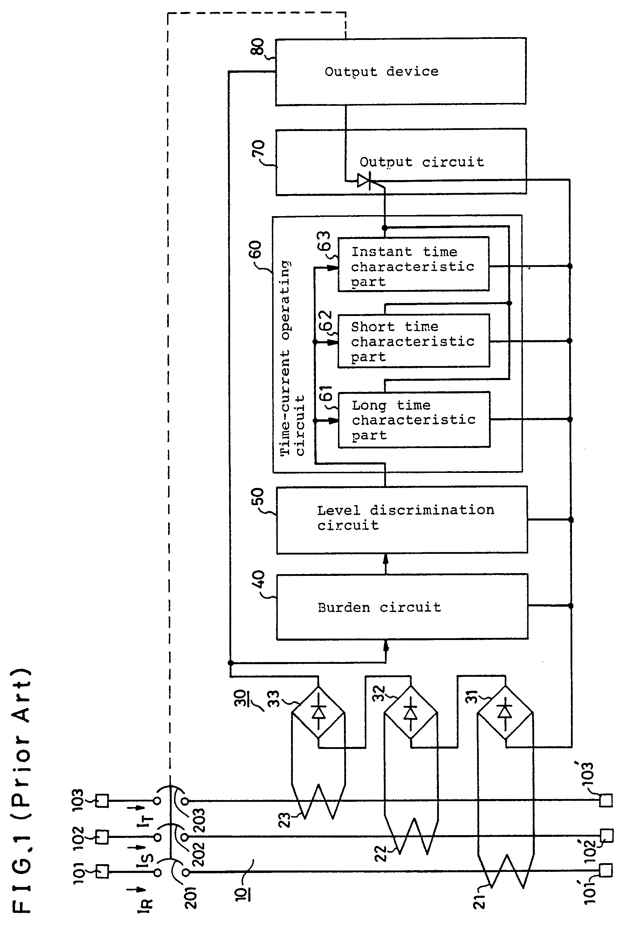

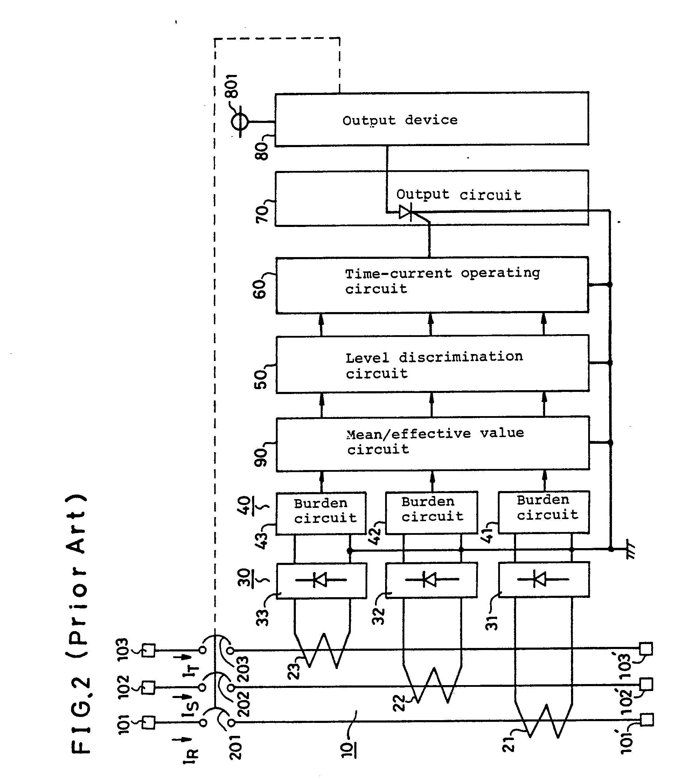

Hitherto, there has been, as an apparatus of a kind of the present invention such prior art apparatus as shown in Fig. 1 wherein a highest peak value of respective current of respective phase is detected, or another apparatus as shown in Fig. 2 wherein effective values of mean values of currents of respective phases of a set of power line are detected.

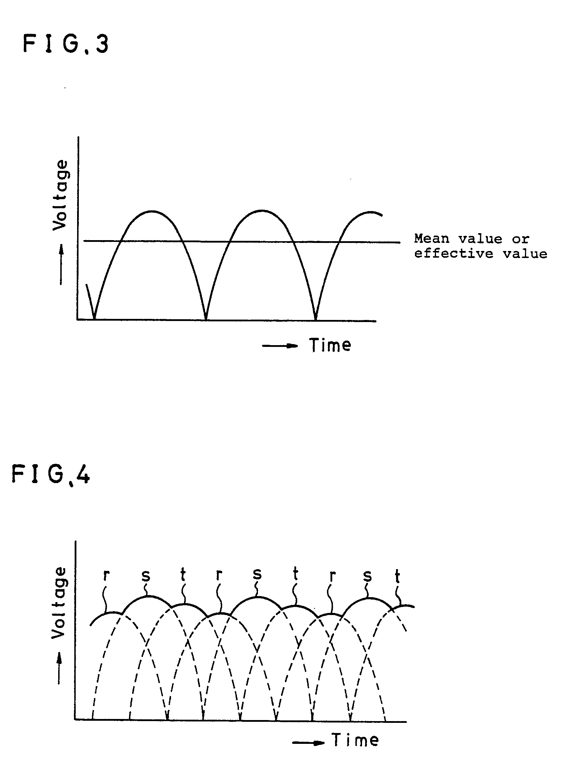

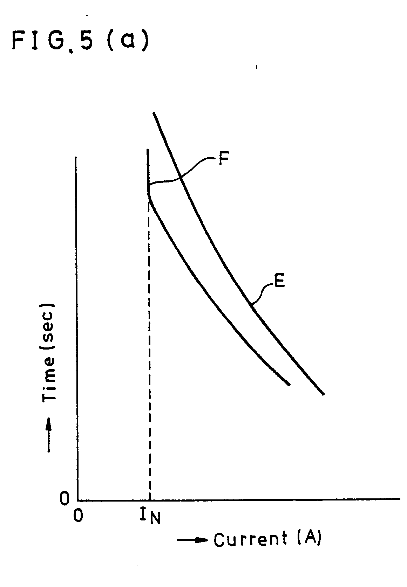

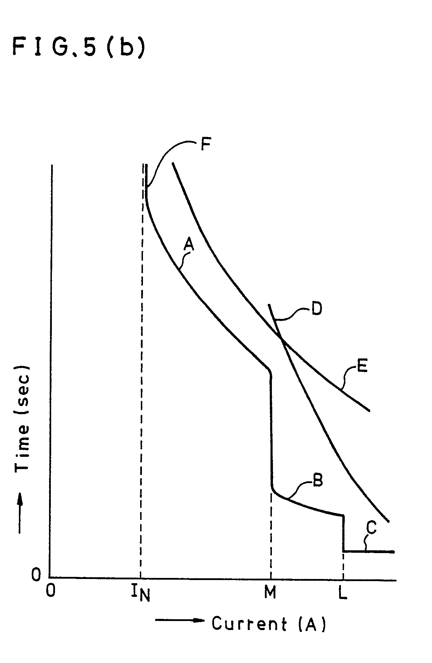

In the conventional apparatus of highest peak detection type of Fig. 1, on a set of AC lines R, S and T connected between power source side terminals 101, 102, 103 and load side terminals 101', 102' and 103', respectively, of three phases power lines 10, current transformers 21, 22 and 23 of a current sensor means 200 are provided, respectively. When an overcurrent flows in one or any lines of the power lines 10, transformed secondary currents flow through secondary coils of the current transformers 21, 22 and 23, respectively, and therefrom to full-wave rectifier circuits 31, 32 and 33, which are connected across the secondary coils. Accordingly, a burden circuit 40, which is connected across series-connected rectified-output-terminals of the full-wave rectifiers 31, 32 and 33, detects a signal for the largest one of the rectified DC current which corresponds to the largest overcurrent among the currents of the three lines R, S and T. Fig. 3 shows a waveform of a full-wave rectifier. The burden circuit 40 comprises a resistance for transforming the current output of the peak value detection circuit 30 to a voltage output and a potentiometer for adjusting the output DC voltage to an appropriate voltage. Fig. 4 shows waveform of the output voltage of the burden circuit 40. The output of the burden circuit 40 is given to a level discrimination circuit 50 which discriminates the output voltage of the burden circuit 40 being below predetermined voltage level, to issue an output signal. The output signal of the level discrimination circuit 50 is given to a time-current tripping circuit 60 which gives an operating signal responding to input signal levels. The time-current operating circuit 60 operates to issue an operating signal for tripping responding to time of continuation and level of output signal of the level discrimination circuit 50. Generally, the relation between the input signal level from the level discrimination circuit 50 and the tripping time is determined by considering heat resisting capacity of the power lines as shown in Fig. 5, wherein the tripping characteristic is of an inverse curve with regard to time and current on a graph when both the abscissa (current) and ordinate (time) are graduated in logarithmic scales. After a lapse of a predetermined time from starting of the above-mentioned time-current operating circuit 60, the time-current operating circuit 60 issues an output signal to an output circuit 70, which responding to its input circuit actuates an output device 80, for instance, a tripping means of a circuit interrupter, to resultantly actuate releasing contacts 201, 202 and 203 of the lines R, S and T, respectively, of the power lines.

As has been described with reference to Fig. 1, in the highest peak value detection type apparatus of Fig. 1, the voltage induced across both ends of the burden circuit 40 is, as shown in Fig. 4. The voltage waves for respective phase currents are different responding to the difference of overcurrents on the lines. That is, the apparatus of Fig. 1 works responding to a peak value of an overcurrent, and therefore a sharp peak in one phase only in a very short instance makes the apparatus work. In other words, the apparatus of Fig. 1 is substantially of the peak detection type, and therefore, this type apparatus can not detect the overcurrent being based on mean values or effective values for each phases for accurate detection of the overcurrent.

The time-current operating circuit 60 comprises a long time characteristic part 61, a short time characteristic part 62 and an instant time characteristic part 63, which are receiving output signal from the burden circuit 40. The long time characteristic part 61 produces a long time characteristic of curve A of Fig. 5(b), and the short time characteristic part 62 produces the short time characteristic as shown by curve B, and the instant time characteristic part 63 produces the instant time characteristic as shown by horizontal part C, respectively of Fig. 5(b). In Fig. 5(b) wherein both the abscissa (current) and the ordinates (time) are graduated in logarithmic scales, a curve D shows time-current characteristic of heat resistant capacity of power lines and a curve E shows a time-current characteristic of heat resistance capacity of loads. Since the curves D and E are of inverse shape as a whole, the curves A, B and C are of inverse type with respect to the current and time as a general view. The long time characteristic part 61, the short time characteristic part 62 and the instant time characteristic part 63 respectively produce output signal to be given to the output circuit 70 when level of the input signal becomes above respective predetermined levels. The output circuit 70 comprises, for instance, a thyristor 120 to be turned on by the output signal of the time-current operating circuit 60, thereby to actuate, for instance, a tripping device as the output device, thereby to release the interruption connectors 201, 202 and 203 to open the circuit connection in the power line.

Fig. 2 shows a representative conventional example of the mean effective value detection type apparatus. Operation characteristic of the apparatus of this kind is used for the operation of relatively long operation time such as for an overload protection relay of an electric motor, but not for instantaneous operation. In Fig. 2, the same numerals designate the corresponding parts and components to the first conventional example. The difference from the conventional apparatus of the first example is that the output terminals of the rectifier circuits 31, 32 and 33 are respectively connected to both ends of the burden circuits 41, 42 and 43, respectively, and each one end of the burden circuit 41, 42 and 43 are connected in common to the ground. And, output terminals of the burden circuits 41, 42 and 43 are connected to three input terminals of a mean/effective value circuit 90, wherein input signals from the burden circuits 41, 42 and 43 are rectified thereby to produce DC output signals representing mean value or effective value of the input signals. Respective three output signals of the mean/effective value circuit 90 are given to the level discrimination circuit, and respective three output signals of the level discrimination circuit 50 are given to a time-current operating circuit 60. The time-current operating circuit 60 is constituted, generally to have the operation curve F shown in Fig. 5, which has a relatively long operation time characteristic. The output signals of the time-current operating circuit 60 are further given to an output circuit 70 which further gives output signals to an output apparatus 80, which is fed with power from an auxiliary source supply 801.

In the mean value type or effective value type conventional solid state overcurrent detector of Fig. 2, overcurrents in respective phases are accurately detected by producing mean value or effective value of the overcurrent by the mean/effective value circuit 90. On the other hand, this type apparatus has a shortcoming that its detection response is not sufficiently high since the mean/effective value circuit, which substantially have to contain integration circuits therein and having relatively long time constant. Accordingly, the conventional apparatus of mean/effective value detection type of Fig. 2 is not suitable for detection of short-circuit currents or the like instantaneously increasing overcurrent.

A circuit interrupter with multiple display and parameter entry means is known from GB—PS 2 073 968. This circuit interrupter includes a trip unit, and a display and control panel comprising a numeric display device and a plurality of legends associated with light-emitting diodes. The panel presents a sequential display of numeric values of associated circuit electrical parameters and time-current trip characteristic as set by adjusters, the currently visible numeric quantity being identified by an energized light emitting diode and associated legend. The control panel also includes a test switch for initiating a test operation and a potentiometer for selecting a desired simulated fault current value for the test operation. The test capability is provided simultaneously with normal circuit breaker operation which maintains protection of the associated circuit.

The main trip unit circuitry of said circuit interrupter includes an information processor and sequence controller which may be, for example, a type 8048 microcomputer. So, this type circuit interrupter has a shortcoming that its response to large overcurrents is not very quick since it needs processing time.

Summary of the invention

Primary purpose of the present invention is to provide a solid state overcurrent detector and an improved circuit interrupter which comprises the solid state overcurrent detector.

The solid state overcurrent detector in accordance with the present invention comprises:

current sensor means provided for respective phases of AC power lines for issuing a first output signal corresponding to effective values or mean values of currents of respective phases and a second output signal corresponding to a highest peak value of the currents of respective phases,

first level discrimination means constituted by a microcomputer for discriminating levels of the first output signal of the current sensor means,

first time-current operating means constituted by a microcomputer for issuing a first time-current operating signal responding to output signal of the first level discrimination means,

first output means for issuing overcurrent detection signal responding to output signal of the first time-current operating means,

second level discrimination means for discriminating level of the second output signal from the current sensor means, without the aid of the microcomputer,

second time-current operating means for issuing a second time-current operating signal without the aid of the microcomputer, this operating signal is responding to the output signal of the second discrimination means, and

said second level discrimination means and said second time-current operating means being connected in a substantially direct way without data processing with each other, and

second output means for issuing overcurrent detection signal responding to the output signal of the second time-current operating means receiving both output signals of said first and second time-current operating means through an OR circuit.

A circuit interrupter in accordance with the present invention comprises:

disconnectable contacts provided in respective lines of a set of AC power lines,

a releasing device for actuation of disconnection of the disconnectable contacts, and

control means for controlling operations of the actuation means responding to an overcurrent under a predetermined condition,

the control means comprising:

current sensor means provided for respective phases of the AC power lines for issuing a first output signal corresponding to effective values or mean values of currents of respective phases and a second output signal corresponding to a highest peak value of the currents of respective phases,

first level discrimination means for discriminating levels of the first output signal of the current sensor means,

first time-current tripping means for issuing a first time-current tripping signal responding output signal of the first level discrimination means,

first output means for issuing overcurrent detection signal responding to output signal of the first time-current tripping means,

second level discrimination for discriminating level of the second output signal from the current sensor means,

second time-current tripping means for issuing a second time-current tripping signal responding output signal of the second discrimination means, and

second output means for issuing overcurrent detection signal, responding to output signal of the second time-current tripping means.

The solid state overcurrent detector and the circuit interrupter in accordance with the present invention can carry out three kinds of operations responding to amount of overcurrent. That is, when the overcurrent is within a predetermined range, the overcurrent is detected taking account of heat resistance capacity of power lines and load connected thereto by basing on a maximum value among effective values or mean values of currents in respective phases. On the other hand, when the overcurrent is larger than the above-mentioned range, for instance, in case of short-circuit current, an instantaneous peak value of any phase of the current as such is detected. In general, a large current of this kind can be considered as that of sinusoidal wave, and in this case, it is possible to carry out reduction from peak value to values corresponding to effective value or mean value. And, the circuit interrupter is actuated by means of such detected peak value. As a result of the above-mentioned general arrangement, the electric power lines and load are most preferably protected from accident, and as well, undesirable interruption of power service at an overcurrent of a negligibly short instance can be avoided. Furthermore, taking account of charging and discharging of heat in the electric power lines and load, most appropriate monitoring and protection thereof can be carried out by the apparatus of the present invention.

Brief description of the drawing

Fig. 1 is the circuit block diagram of the representative conventional solid state overcurrent detector or a circuit interrupter.

Fig. 2 is the circuit block diagram of another type representative conventional example of a solid state overcurrent detector or a circuit interrupter.

Fig. 3 is a graph showing waveform in the circuit of Fig. 1 or Fig. 2.

Fig. 4 is a graph showing waveform in another circuit in Fig. 1 or Fig. 2.

Fig. 5(a) is the current vs. time characteristic graph of heat resistance capacity of general electric power lines and the required overcurrent detection characteristic for such electric power lines.

Fig. 5(b) is the current vs. time characteristic graph of the conventional solid state overcurrent detector or the conventional circuit interrupter of Fig. 1.

Fig. 6 is a circuit block diagram of a first embodiment in accordance with the present invention.

Fig. 7 is a detailed circuit diagram of a microcomputer 110 of the circuit of Fig. 6.

Fig. 8 is a flow chart showing operation of the microcomputer shown in Fig. 7.

Fig. 9 is a circuit block diagram of a second embodiment in accordance with the present invention.

Fig. 10 is a circuit block diagram of still another embodiment.

Description of the preferred embodiment

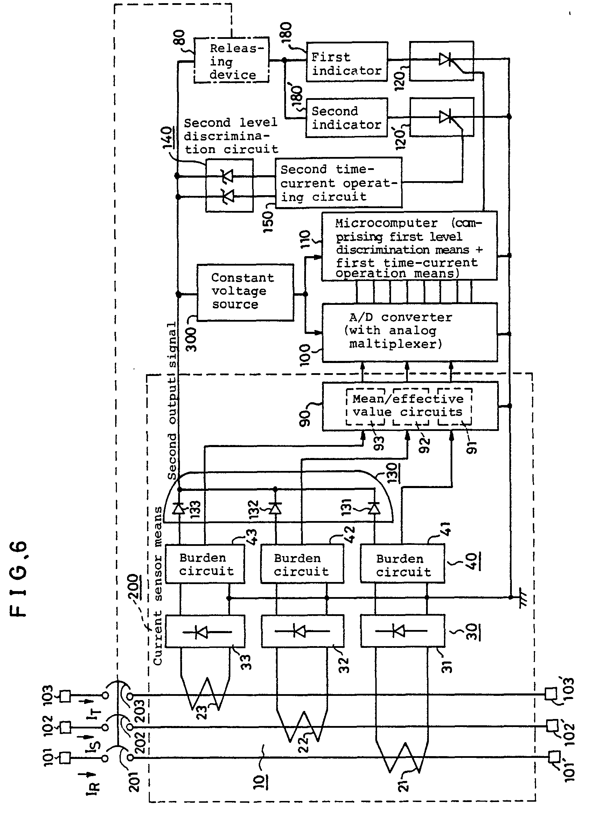

Hereinafter, details of the invention is described with reference to the drawings Fig. 6 and thereafter.

In a first embodiment shown in Fig. 6, on a set of power lines R, S and T of three phase power lines 10, current transformers 21, 22 and 23 of a current sensor means 200 are provided, respectively. Full-wave rectifiers 31, 32 and 33 are connected with its two input lines across both output lines of the current transformers 21, 22 and 23, respectively. Burden circuits 41, 42 and 43 are connected with their input lines to output lines of the full-wave rectifiers 31, 32 and 33, respectively, and each one of the input lines of the burden circuits 41, 42 and 43 are connected in common to the ground. The other input terminals of the burden circuits 41, 42 and 43 are connected to input terminals of an OR circuit 130, which consists of three diodes 131, 132 and 133 and output terminal of which are connected in common as an output terminals of the OR circuit 130. Adjustable output terminals of the burden circuits 41, 42 and 43, wherefrom output signals can be obtainable in desirably adjusted levels, are connected to input terminals of mean/effective value circuits 91, 92 and 93 of mean/effective value means 90, which are for producing mean values or effective values of the signals from the burden circuits 41, 42 and 43. The output terminals of the mean/effective value circuits 91, 92 and 93 are connected to input terminals of an A/D converter 100. A microcomputer 110 is connected to the output terminal of the A/D converter 100. The output terminal of the OR circuit 130, as a second output terminal of the sensor means 200, is connected to the A/D converter 100 and the microcomputer 110 through a power source circuit 300, which is generally a constant voltage circuit. Furthermore, the second output terminal of the current sensor means 200 is connected to a second level discrimination circuit 140 which, for instance, comprises at least one zener diode. The second level discrimination circuit 140 is connected to a second time-current tripping circuit 150. Output terminals of the microcomputer 110 and the second time-current operating circuit 150 are connected to a first and a second output circuit 120 and 120', respectively, for instance, comprising each one thyristor, for actuating a common device, for instance, a releasing device 80 for carrying out disconnection of line switches 201, 202 and 203. A first indicator 180 and a second indicator 180' are for indicating which circuit has operated. The microcomputer 110 comprises a first level discrimination means and a first time-current operating means as is described later herein.

The current sensor means 200 issues from the mean/effective value circuit 90 signals corresponding to mean values or effective values of the current in the power lines R, S and T, and also issues from the OR circuit 130 the second output signals corresponding to peak value of the current in the power lines R, S and T. The second output signal of the current sensor means 200 is given through the second level discrimination circuit 140 to the second time-current operating circuit 150. The A/D converter 100 has an analog-multiplexer part for time-sharingly select input signals of the mean/effective value circuits 91, 92 and 93 in turn, to carry out A/D conversion. The outputs of the A/D converter 100 is given to the microcomputer 110. The A/D converter 100 and the microcomputer 110 are fed with a constant voltage D/C current from the power source circuit 300. The output signal of the microcomputer 110 is given to a first output circuit 120. The first output device is the first operation indicator 180 plus a releasing device 80 of an interrupter by which moving contacts 201, 202 and 203 are drived. The second output device is the second indicator 180' and the same releasing device 80. Thus, by means of the operation of the first or the second indicator, reason of disconnecting operation of the interrupter is shown.

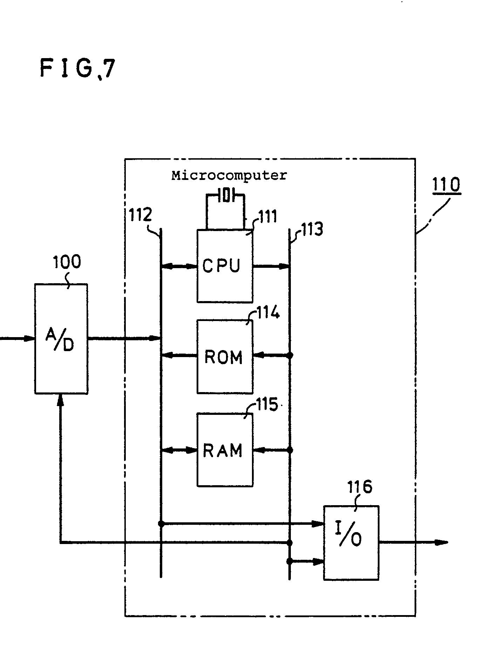

Fig. 7 is a circuit block diagram of the microcomputer 110. As shown in Fig. 7, the microcomputer 110 comprises a central processor unit 111, a read-only memory 114, a random-access memory 115, an I/O port 116, a data bus 112 and an address bus 113. Parts of the data bus 112 and the address bus 113 are also connected to the A/D converter 100. The read-only memory 114 contains a program for executing necessary signal processing, and also data for a long time characteristic, a short time characteristic and an instant time characteristic of the first time-current operating means. The central processor unit 111 contains clock signal means necessary therefor. The random-access memory 115 functions as a register which is necessary for the signal processing.

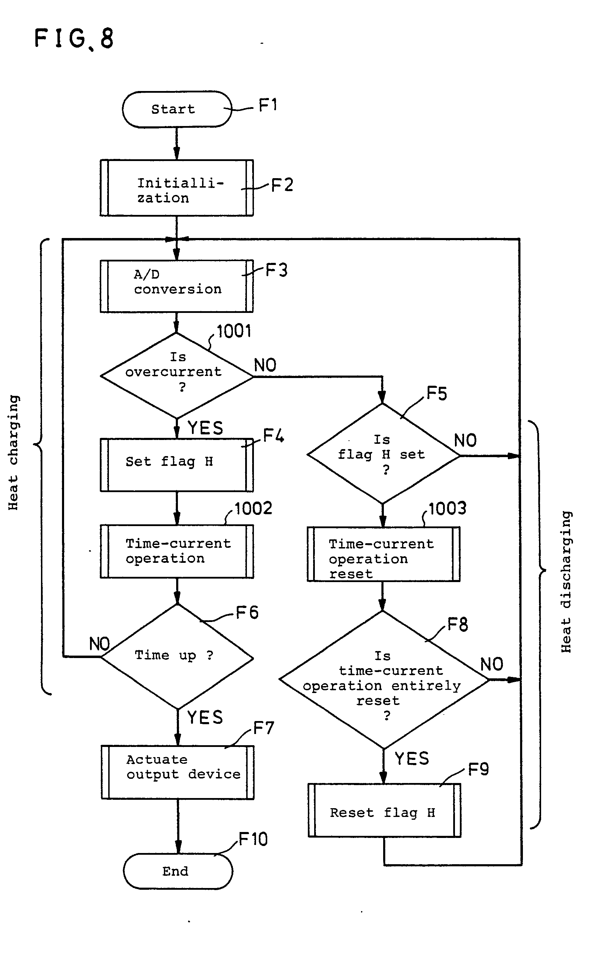

Signal processing flow of the above-mentioned microcomputer 110 is described with reference to a flow chart shown in Fig. 8. As shown in Fig. 8, the microcomputer contains as fundamental functions, at least the first level discrimination means 1001 for discriminating level of input signal from the A/D converter 100 and the first time-current operation means 1002 for producing necessary time-current characteristic responding to input signal from the A/D converter. Furthermore, the microcomputer contains a resetting means 1003, which is constituted in a manner to carry out a resetting, with a predetermined resetting time-schedule, when at least one of said first time-current operating means 1002 and said second time-current operating means 150 falls below respective predetermined levels. The time schedule is designated to correspond to decrease rate of heat discharging characteristics of the electric power lines and the loads.

The operation of the embodiment configured as above-mentioned is as follows: when overcurrent(s) flows in the AC power lines 10, output currents of the current transformers 21, 22 and 23, coupled to the AC power lines R, S and T of the AC power lines 10, correspondingly produces output currents at predetermined transforming ratios. The output currents are rectified by the full-wave rectifiers 31, 32 and 33, respectively. The rectified output currents of the full-wave rectifiers 31, 32 and 33 are fed to respective burden circuits 41, 42 and 43. The wave forms of the signal voltages induced across the burden circuits 41, 42 and 43 becomes as shown in Fig. 3. The output signals of the burden circuits 41, 42 and 43 are transformed into mean values or effective values thereof by mean/effective value means 91, 92 and 93 of the mean/effective value circuit 90. Then the output signals of the mean/effective value circuit 90 are given to A/D converter 100, wherein the analog multiplexer part time-sharingly selects and A/D converts the input signal into digital signals. These digital signals are fed to the microcomputer 110. The microcomputer 110 carries out level discrimination of digital input signal thereto in accordance with a predetermined program stored in the read-only memory 114. Furthermore, basing on the results of the level discrimination, a predetermined time-current operation is carried out, thereby to issue output signal from the output port 116. That is, the microcomputer 110 functions as the first level discrimination means and the first time-current operating means. The above-mentioned time-current operation is carried out, for instance, along the inverse long time-current characteristic of part A of Fig. 5(b). The output signal issues from the output port 116 of the microcomputer 110 is fed to the gate of the thyristor 120, which is then turned on to drive the output device 80. Accordingly, the overcurrent indicator 180 indicates the occurrence of the overcurrent and at the same time the releasing device 80 actuate the interrupting connectors 201, 202 and 203. The above-mentioned time-current characteristic of the curves A, B and C are designed by taking account of the capacity of fuses in the upper stream part of the power line 10.

On the other hand, the output of the full-wave rectifier 31, 32 and 33 are given to the OR circuit 130 consisting of diodes 131, 132 and 133. Since the output terminal of the OR circuit 130 is connected to the second level discrimination circuit 140 which, for instance, comprises at least one zener diode. When one input signal to the OR circuit 130 exceeds the second level, the discrimination circuit 140 gives output signal to the second time-current operating circuit 150, which accordingly carries out necessary time-current operation, and thereby triggers the gate of the thyristor 120'. The time-current operation in this case is, for instance, as shown by the part B of the short time current inverse characteristic or the part C of the instantaneous time-current characteristic. By the above-mentioned turn-on of the thyristor 120', the output device 80 is actuated, thereby its indicator 180' indicates the kind of the overcurrent and also drives the interruption connectors 201, 202 and 203. As the output device 80, use of a low power consumption type release device is recommendable. Since simple OR circuit 130 is combined with simply configurated second level discrimination circuit 140, the second time current operation circuit 150 can respond very quick to a large overcurrent without any delay.

Instead of the above-mentioned OR circuit 130 consisting of three diodes 131, 132 and 133, an OR circuit may be constituted with utilizing known highest value selection function of the microcomputer 110 by utilizing a part thereof. In such case, in the flow chart of Fig. 8, between the A/D conversion step F3 and the first level detection step 1001, a known sub-routine for the function of the highest value selection, which is substantially the same as the OR circuit 130, may be inserted.

Nextly, detailed signal processing in the microcomputer 110 is described with reference to the main flow chart of Fig. 8: Firstly, when the microcomputer 110 is started into an operable state, the program starts at F1 and the system is initiallized in F2. Namely, I/O port is set, flags are set and necessary resets are made, and the flow comes to main processing flow. Nextly, operation of the A/D converter 110 containing the analog multiplexer part is executed. In this controlling operation, effective values or mean values of currents corresponding to the currents in the power lines R, S and T are time-sharingly selected, A/D converted and stored in the random access memory 115 in the microcomputer 110. Then, discrimination operation is executed such that, with respect to input signal data stored in the random access memory 115, the discrimination whether the input data are overcurrent or not is executed, in the step 1001. When the input data are not an overcurrent, the flow goes back to the step F3 through F5. Nextly, when an overcurrent comes, firstly flag H for representing heat charging is set in the step F4, and bits for heat charging is added for every predetermined unit times by utilizing random access memory 115 or a register in the central processor unit 114, so as to count time responding to amount of input signal level. The heat charging bits are selected in order to realize time-current operation along the characteristic curves of Fig. 8. Then, the added bits number is discriminated to examine whether the time is up for the selected time-current operation of the predetermined characteristic. And as a result, when the added bit number does not yet reach the predetermined number, the flow goes back from the step F6 to the step F3. When the added bits number reaches the predetermined number. In other words, the time is up, output is issued through the I/O port 116 to drive the thyristor 120, thereby to actuate the first indicator 180 and the output device 80. The steps F3 through F7 work as starting means.

Nextly, operation of heat discharging routine, namely, the routine for resetting the time-current operation is described. As above-mentioned, when the heat charging flag H is set and time is being count to some extent, and A/D converted digital data become below the predetermined level, the flow gets out of the level discrimination routine of 1001? And setting of heat charging flag H for representing the state immediately before itself is discriminated by the step F5. As a result, when the heat charging flag H is not set, the flow goes back to the A/D conversion step of F3. On the contrary when the heat charging flag H is set, from the bit number accumulated during the heat charging routine, discharge bit number is subtracted at the step 1003 at every predetermined unit times. When balance of counted number of the bit becomes 0 as a result of the subtractions in the step 1003, the heat charging flag H is reset in the step F9. And the heat discharging routine goes back from the step F9 to the A/D conversion step F3. When the counted number of the bit is not entirely reset, the heat charging flag H is not reset and the heat discharging routine goes back from the step F8 to the A/D conversion step F3. The steps F3 through F9 works as resetting means.

As above-mentioned, the microcomputer gives most appropriate time-current operating characteristic taking account of heat charging and heat discharging in the electric power lines and loads. Incidentally, addition or subtraction of the heat charging and heat discharging can be executed in the inverse order to the above-mentioned embodiment.

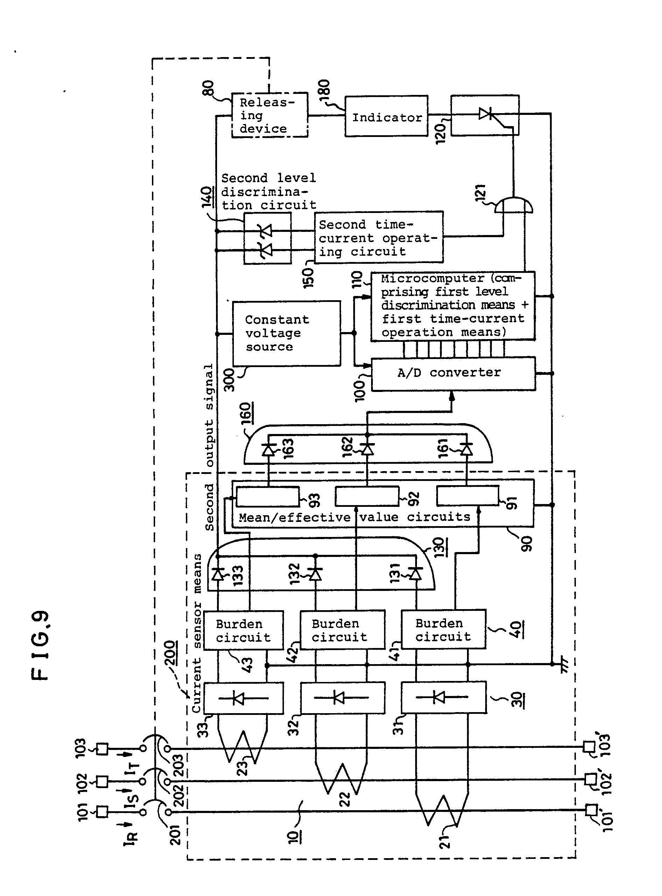

Fig. 9 shows another embodiment in accordance with the present invention, wherein an OR circuit 160 consisting of three diodes 161, 162 and 163 which receives output signals of the mean/effective value circuits 91, 92 and 93, respectively and issues output signal to the A/D converter 100. And the output signals of the microcomputer 110 and the second time-current operating circuit 150 are given through an OR circuit 121 to a single indicator 180 and a single output device 80. Other parts and components are substantially the same as the first embodiment of Fig. 6. As a result of the above-mentioned configuration, the A/D converter 100 receives the largest signal among the output signals of the mean/effective value circuits 91, 92 and 93. By comprising the OR circuit 160 for selectively issuing highest value of the output signals of the mean/effective value circuits 91, 92 and 93, this embodiment does not need any analog multiplexer in the A/D converter 100. Accordingly, the operation of the microcomputer and A/D converter becomes simpler than the example of Fig. 6. Since the OR circuit 160 is used, the highest output signal of the mean/effective value circuits 91, 92 and 93 corresponding to the highest overcurrent in all phases, is given as the input signal to the A/D converter 100 without delay, even at an overcurrent only in one phase, the circuit can detect the overcurrent in a very short time.

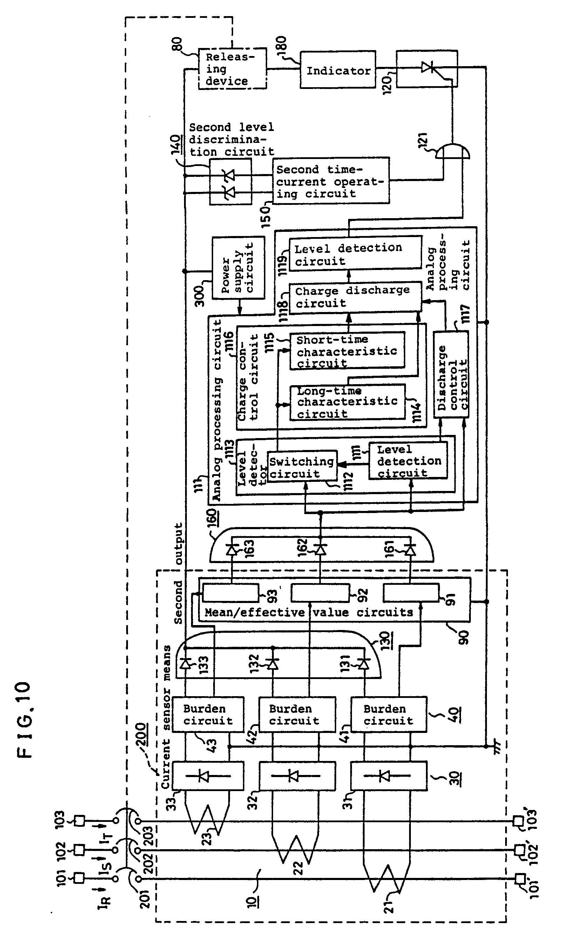

Apart from the above-mentioned embodiments utilizing the microcomputer 110, the function of the computation can be made by an analog computer, too. Such embodiment is shown in Fig. 10, wherein an analog processing circuit 111 is provided instead of the A/D converter 100 and the microcomputer 110 of the previous embodiments. The analog processing circuit 111 comprises a level detector 1113 having a level detection circuit 1111 and a switching circuit 1112, a charge control circuit 1116 having a long-time characteristic circuit 1114 and a short-time characteristic circuit 1115, a discharge control circuit 1117, a charge discharge circuit 1118 and a level detection circuit 1119. When the level detection circuit 1111 detects an overcurrent through the intensity of the signal from the OR circuit 160, it makes the switching circuit 1112 to issue an output to the charge control circuit 1116. Then, either of the long-time characteristic circuit 1114 or the short-time characteristic circuit 1115 of the charge control circuit 1116 issues output to the charge-discharge circuit 1118, which comprises a capacitor and several resistors. The charge control circuit 1116 functions for the heat charging routine of the flow chart of Fig. 8, and the discharge control circuit 1117 functions for the heat discharging routine of the flow chart of Fig. 8. Then the level detection circuit 1119 issues a first time-current operating signal.

In the above-mentioned embodiments of the present invention, as the current sensor means 200, any current sensor means such as Hall, magnetic resistance device or the like combined with suitable amplifier can be utilized instead of the circuit shown in the embodiments. Furthermore, as a means to obtain absolute value of the detected current, known means using operational amplifiers may be used. Moreover, by individually connecting indicators to the first time-current operating output and the second time-current operating output, finding of overcurrent or trouble on the individual phase is possible. Furthermore, by providing the heat discharging routine in the microcomputer 110 or the computing part 110', most appropriate protection in view of heat charging and discharging is obtainable, thereby enabling attainment of improved power supply service, as well as, higher protection of the power lines and loads.

## Claims

1. A solid state overcurrent detector comprising:
   a current sensor means (200) provided for respective phases of AC power lines (10) for issuing first output signals corresponding to effective values or mean values of currents of respective phase and a second output signal corresponding to a highest peak value of said currents of respective phases,
   first level discrimination means (110) constituted by a microcomputer for discriminating levels of said first output signal of said current sensor means (200),
   first time-current operating means (110) constituted by a microcomputer for issuing a first time-current operating signal responding to output signal of said first level discrimination means (110),
   first output means (120) for issuing overcurrent detection signal responding to output signal of said first time-current operating means (110), characterized by further comprising:
   second level discrimination means (140) for discriminating level of said second output signal from said current sensor means (200) without the aid of the microcomputer,
   second time-current operating means (150) for issuing a second time-current operating signal without the aid of the microcomputer, this operating signal responding to the output signal of said second discrimination means (140), and
   said second level discrimination means (140) and said second time-current operating means (150) being connected in a substantially direct way without data processing with each other, and
   second output means (120', 121) for issuing over-current detection signal responding to the output signal of said second time-current operating means, receiving both output signals of said first and second time-current operating means through an OR circuit.

2. A solid state overcurrent detector in accordance with claim 1, which further comprises:
   peak value detection means provided as a stage between said current sensor means (200) and said first level discrimination means (110) for detecting a peak value among said output signals of said current sensor means (200) and issuing an output signal to said first time-current operating means (110).

3. A solid state overcurrent detector in accordance with claim 2, wherein
   said first peak detection means is a diode OR circuit (160).

4. A solid state overcurrent detector in accordance with claim 1, 2 or 3, wherein
   said current sensor means comprises burden circuits (40) connected with its one end to a common potential point, and a diode OR circuit (130) for obtaining said second output signal from the output signals of said burden circuits (40).

5. A solid state overcurrent detector in accordance with claim 1, 2 or 3, wherein

at least one of said first time-current operating means (110) or said second time-current operating means (150) comprises starting means for starting time-current operation when input signal becomes above a predetermined level and a resetting means for resetting said time-current operation when said input signal becomes below a predetermined level.

6. A solid state overcurrent detector in accordance with claim 5, wherein

when input signal to at least one of said first (110) and second (150) time-current operating means becomes below a predetermined level, said resetting means carries out a resetting along a predetermined heat discharging rate characteristic.

7. A solid state overcurrent detector in accordance with claim 1, 2, 3 or 6, wherein

said first time-current operating means (110) has an inverse time-current characteristic.

8. A solid state overcurrent detector in accordance with claim 1, 2, 3 or 6 wherein

said second time-current operating means (150) has an instant-responsive characteristic.

9. A solid state overcurrent detector in accordance with claim 1, 2 or 3, wherein

said current sensor means (200) has a means (30) for rectifying detection current into DC current, thereby feeding it as operation power for whole circuit of the solid state overcurrent detector.

10. A solid state overcurrent detector in accordance with claim 1, 2 or 3, characterized in that said first (120) and second (120') output means are separate means whereby said first output means (120) receives an output signal of said first time-current operating means (110) and said second output means (120') receives an output signal of said second time-operating means (150).

11. A circuit interrupter comprising:

disconnectable contacts (201, 202, 203) provided in respective lines of a set of AC power lines (10), a releasing device (80) for actuation of disconnection of said disconnectable contacts (201, 202, 203), and

control means for controlling operations of said releasing means responding to an overcurrent under a pre-determined condition,

said control means comprising:

current sensor means (200) provided for respective phases of said AC power lines (10) for issuing a first output signal corresponding to effective values or mean values of currents of respective phases and a second output signal corresponding to a highest peak value of said currents of respective phases

first level discrimination means (110) constituted by a microcomputer for discriminating levels of said first output signal of said current sensor means,

first time-current tripping means (110) constituted by a microcomputer for issuing a first time-current tripping signal responding to output signal of said first level discrimination means (110),

first output means (120) for issuing overcurrent detection signal responding to output signal of said first time-current tripping means (110), characterized by further comprising:

second level discrimination means (140) for discrimination level of said second output signal from said current sensor means (200) without the aid of the microcomputer,

second time-current tripping means (150) for issuing a second time-current tripping signal without out the aid of the microcomputer, this operating signal responding to the output signal of said second discrimination means (140), and

said second level discrimination means (140) and

said second time-current tripping means (150) being connected in a substantially direct way without data processing with each other, and

second output means (120', 121) for issuing over-current detection signal responding to the output signal of said second time-current tripping means, receiving both output signals of said first and second time-current operating means through an OR circuit.

12. A circuit interrupter in accordance with claim 11, which further comprises:

peak value detection means provided as a stage between said current sensor means (200) and said first level discrimination means (110) for detecting a peak value among said output signals of said current sensor means and issuing an output signal to said first time-current tripping means.

13. A circuit interrupter in accordance with claim 12, wherein

said first peak detection means is a diode OR circuit (160).

14. A circuit interrupter in accordance with claim 11, 12, or 13, wherein

said current sensor means comprises burden circuits (40) connected with its one end to a common potential point, and a diode OR circuit (130) for obtaining said second output signal from the output signals of said burden circuits (40).

15. A circuit interrupter in accordance with claim 11, 12, or 13, wherein

at least one of said first time-current tripping means (110) or said second time-current tripping means (150) comprises starting means for starting time-current operation when input signal becomes above a predetermined level and a resetting means for resetting said time-current operation when said input signal becomes below a predetermined level.

16. A circuit interrupter in accordance with claim 15, wherein

when input signal to at least one of said first and second time-current operating means (150) becomes below a predetermined level, said resetting means carries out a resetting along a predetermined heat discharging rate characteristic.

17. A circuit interrupter in accordance with claim 12, 13 or 14 wherein

said first time-current tripping means (110) has an inverse time-current characteristic.

18. A circuit interrupter in accordance with claim 12, 13 or 14 wherein said second time-current tripping means (150) has an instant-responsive characteristic.

19. A circuit interrupter in accordance with claim 11, 12 or 13, wherein

said current sensor means (200) has a means (30) for rectifying detection current into DC current, thereby feeding it as operation power for said control means.

20. A circuit interrupter in accordance with claim 11, 12, or 13, characterized in that said first (120) and second (120') output means are separate means whereby said first output means (120) receives an output signal of said first time-current tripping means (110) and said second output means (120') receives an output signal of said second time-tripping means (150).

**Patentansprüche**

1. Ein Festkörperüberstromdetektor mit:

einer Stromsensorvorrichtung (200), welche den jeweiligen Phasen von Wechselstromleitungen (10) bereitgestellt ist zur Aussendung von ersten Ausgangssignalen entsprechend den Effektivwerten oder Mittelwerten der Ströme der entsprechenden Phasen und eines zweiten Ausgangssignals entsprechend einem höchsten Spitzenwert des Stromes der jeweiligen Phasen,

einer ersten Pegeldiskriminationsvorrichtung (110), welche eingerichtet ist durch einen Mikrocomputer zum Diskriminieren von Pegeln des ersten Ausgangssignals der Stromsensorvorrichtung,

einer ersten Zeitstrombetriebsvorrichtung, welche eingerichtet ist durch einen Mikrocomputer zur Aussendung eines ersten Zeitstrombetriebssignals entsprechend dem Ausgangssignal der ersten Pegeldiskriminationsvorrichtung (110),

einer ersten Ausgangsvorrichtung (120) zur Aussendung eines Überstromdetektionssignals entsprechend dem Ausgangssignal der ersten Zeitstrombetriebsvorrichtung (110), dadurch gekennzeichnet, daß er desweiteren aufweist:

eine zweite Pegeldiskriminationsvorrichtung (140) zum Diskriminieren des Pegels des zweiten Ausgangssignals von der Stromsensorvorrichtung (200) ohne Mitwirkung des Mikrocomputers,

eine zweite Zeitstrombetriebsvorrichtung (150) zum Aussenden eines zweiten Zeitstrombetriebssignals ohne Mitwirkung des Mikrocomputers, wobei dieses Betriebssignal dem Ausgangssignal der zweiten Diskrimationsvorrichtung (140) entspricht, und

wobei die zweite Pegeldiskriminationsvorrichtung (140) und die zweite Zeitstrombetriebsvorrichtung (150) im wesentlichen direkt miteinander zusammengeschaltet sind ohne Datenverarbeitung miteinander, und

eine zweite Ausgangsvorrichtung (120', 121,) zur Aussendung eines Überstromdetektionssignals entsprechend dem Ausgangssignal der zweiten Zeitstrombetriebsvorrichtung, wobei beide Ausgangssignale der ersten und zweiten Zeitstrombetriebsvorrichtung durch einen Oder-Schaltkreis empfangen werden.

2. Festkörperüberstromdetektor nach Anspruch 1, welcher desweiteren aufweist:

eine Spitzenwertdetektionsvorrichtung, welche ausgestattet ist als Stufe zwischen der Stromsensorvorrichtung (200) und der ersten Pegeldiskriminationsvorrichtung (110) zur Detektion eines Spitzenwertes unter den Ausgangssignalen der Stromsensorvorrichtung (200), und welche ein Ausgangssignal an die erste Zeitstrombetriebsvorrichtung (110) aussendet.

3. Festkörperüberstromdetektor nach Anspruch 2, wobei die erste Spitzendetektionsvorrichtung ein Dioden-Oder-Schaltkreis (160) ist.

4. Festkörperüberstromdetektor nach Anspruch 1, 2 oder 3, wobei

die Stromsensorvorrichtung Lastschaltkreise (40) aufweist, welche an einem Ende an einem gemeinsamen Potentialpunkt zusammengeschaltet sind, und einen Dioden-Oder-Schaltkreis (130) zur Erlangung des zweiten Ausgangssignals von den Ausgangssignalen der Lastschaltkreise (40).

5. Festkörperüberstromdetektor nach Anspruch 1, 2 oder 3, wobei mindestens eine der ersten Zeitstrombetriebsvorrichtung (110) oder der zweiten Zeitstrombetriebsvorrichtung (150) eine Startvorrichtung aufweist zum Starten des Zeitstrombetriebs, wenn das Eingangssignal größer als ein vorherbestimmter Pegel wird, und eine Zurücksetzevorrichtung zum Zurücksetzen des Zeitstrombetriebs, wenn das Eingangssignal kleiner als ein vorherbestimmter Pegel wird.

6. Festkörperüberstromdetektor nach Anspruch 5, wobei,

wenn das Eingangssignal an mindestens einer der ersten (110) und zweiten (150) Zeitstrombetriebsvorrichtungen kleiner als ein vorherbestimmter Pegel wird, die Zurücksetzevorrichtung ein Zurücksetzen vornimmt entlang einer vorherbestimmten Hitzeentladungsratencharakteristik.

7. Festkörperüberstromdetektor nach Anspruch 1, 2, 3 oder 6, wobei die erste Zeitstrombetriebsvorrichtung (110) eine inverse Zeitstromcharakteristik aufweist.

8. Festkörperüberstromdetektor nach Anspruch 1, 2, 3 oder 6, wobei

die zweite Zeitstrombetriebsvorrichtung (150) eine momentan reagierende Charakteristik aufweist.

9. Festkörperüberstromdetektor Anspruch 1, 2 oder 3, wobei

die Stromsensorvorrichtung (200) ein Mittel (30) zur Gleichrichtung des Detektionsstroms in Gleichstrom aufweist, welcher dabei als Betriebsstrom dem ganzen Schaltkreis des Festkörperüberstromdetektors zugeführt wird.

10. Festkörperüberstromdetektor nach Anspruch 1, 2 oder 3, dadurch gekennzeichnet, daß

die erste (120) und die zweite (120') Ausgangsvorrichtung getrennte Vorrichtungen sind, wobei die erste Ausgangsvorrichtung (120) ein Ausgangssignal der ersten Zeitstrombetriebsvorrichtung (110) empfängt und die zweite Ausgangsvorrichtung (120') ein zweites Ausgangssignal der zweiten Zeitbetriebsvorrichtung (150) empfängt.

11. Schaltkreisunterbrecher mit:

trennbaren Kontakten (201, 202, 203) welche bereitgestellt sind in jeweiligen Leitungen eines Satzes von Wechselstromleitungen (10), einem Freigabebauteil (80) zur Betätigung der Trennung der trennbaren Kontakten (201, 202, 203), und

einer Kontrollvorrichtung zur Betriebsüberprüfung der Auslösevorrichtung als Antwort auf einen überstrom unter einer vorherbestimmten Bedingung, wobei die Kontrollvorrichtung enthält:

eine Stromsensorvorrichtung (200), welche bereitgestellt ist für jeweilige Phasen der Wechselstromleitungen (10) zur Aussendung eines ersten Ausgangssignals entsprechend den Effektivwerten oder den Mittelwerten der Ströme der jeweiligen Phasen und eines zweiten Ausgangssignals entsprechend einem höchsten Spitzenwert der Ströme der jeweiligen Phasen, eine erste Pegeldiskriminationsvorrichtung (110), welche eingerichtet ist durch einen Mikrocomputer zur Diskriminierung von Pegeln des ersten Ausgangssignals der Stromsensorvorrichtung, eine erste Zeitstromauslösevorrichtung (110), welche eingerichtet ist durch einen Mikrocomputer zur Aussendung eines ersten Zeitstromauslösesignals als Antwort auf das Ausgangssignal der ersten Pegeldiskriminationsvorrichtung (110), eine ersten Ausgangsvorrichtung (120) zur Aussendung eines überstromdetektionssignals als Antwort auf das Ausgangssignal der ersten Zeitstromauslösevorrichtung (110), weiter gekennzeichnet durch:

eine zweite Pegeldiskriminationsvorrichtung (140) zur Diskriminierung des Pegels des zweiten Ausgangssignals von der Stromsensorvorrichtung (200) ohne Mitwirkung des Mikrocomputers, eine zweite Zeitstromauslösevorrichtung (150) zur Aussendung eines zweiten Zeitstromauslösesignals ohne die Mitwirkung des Mikrocomputers, wobei das Betriebssignal auf das Ausgangssignal der zweiten Diskriminierungsvorrichtung (140) reagiert, und

wobei die zweite Pegeldiskriminierungsvorrichtung (140) und die zweite Zeitstromauslösevorrichtung (150) im wesentlichen direkt zusammengeschaltet sind ohne Datenverarbeitung untereinander, und

eine zweite Ausgangsvorrichtung (120', 121) zur Aussendung eines Überstromdetektionssignals als Antwort auf das Ausgangssignal der zweiten Zeitstromauslösevorrichtung, wobei beide Ausgangssignale der ersten und zweiten Zeitstrombetriebsvorrichtung durch eine Oder-Schaltung empfangen werden.

12. Schaltkreisunterbrecher nach Anspruch 11, welcher desweiteren aufweist:

eine Spitzenwertdetektionsvorrichtung, welche bereitgestellt ist als Stufe zwischen der Stromsensorvorrichtung (200) und der ersten Pegeldiskriminationsvorrichtung (110) zur Detektierung eines Spitzenwertes unter den Ausgangssignalen der Stromsensorvorrichtung und zur Aussendung eines Ausgangssignals zur ersten Zeitstromauslösevorrichtung.

13. Schaltkreisunterbrecher nach Anspruch 12, wobei

die erste Spitzendetektionsvorrichtung ein Dioden-Oder-Schaltkreis (160) ist.

14. Schaltkreisunterbrecher nach Anspruch 11, 12 oder 13, wobei die Stromsensorvorrichtung Lastschaltkreise (40) aufweist, welche mit ihren einen Enden an einem gemeinsamen Potentialpunkt zusammengeschaltet sind, und einen Dioden-Oder-Schaltkreis (130) zur Erlangung des zweiten Ausgangssignals von den Ausgangssignalen der Lastschaltkreise (40).

15. Schaltkreisunterbrecher nach Anspruch 11, 12 oder 13, wobei

mindestens einer der ersten Zeitstromauslösevorrichtung (110) oder der zweiten Zeitstromauslösevorrichtung (150) eine Startvorrichtung aufweist zum Starten des Zeitstrombetriebs, wenn das Eingangssignal größer als ein vorherbestimmter Pegel wird und eine Zurücksetzevorrichtung zum Zurücksetzten des Zeitstrombetriebes, wenn das Eingangssignal kleiner als ein vorbestimmter Pegel wird.

16. Schaltkreisunterbrecher nach Anspruch 15, wobei

wenn das Eingangssignal zu mindestens einem der ersten und der zweiten Zeitstrombetriebsvorrichtung (150) kleiner als ein vorherbestimmter Pegel wird, die Zurücksetzevorrichtung das Zurücksetzen durchführt entlang einer vorherbestimmten Hitzeentladungsratencharakteristik.

17. Schaltkreisunterbrecher nach Anspruch 12, 13 oder 14, wobei

die erste Zeitstromauslösevorrichtung (110) eine inverse Zeitstromcharakteristik aufweist.

18. Schaltkreisunterbrecher nach Anspruch 12, 13 oder 14, wobei

die zweite Zeitstromauslösevorrichtung (150) eine momentan reagierende Charakteristik aufweist.

19. Schaltkreisunterbrecher nach Anspruch 11, 12 oder 13, wobei

die Stromsensorvorrichtung (200) ein Mittel (30) aufweist zur Gleichrichtung des Detektionsstroms in Gleichstrom, welcher dabei der Kontrollvorrichtung als Betriebsstrom zugeführt wird.

20. Schaltkreisunterbrecher nach Anspruch 11, 12 oder 13, dadurch gekennzeichnet, daß

die erste (120) und die zweite (120') Ausgangsvorrichtung getrennte Vorrichtungen sind, wobei die erste Ausgangsvorrichtung (120) ein Ausgangssignal der ersten Zeitstrombetriebsvorrichtung (110) empfängt und die zweite Ausgangsvorrichtung (120') ein zweites Ausgangssignal der zweiten Zeitbetriebsvorrichtung (150) empfängt.

**Revendications**

1. Un détecteur de surintensité à semiconducteurs comprenant:

des moyens détecteurs de courant (200) pour des phases respectives de lignes de transport d'énergie électrique alternative (10), qui sont destinés à émettre des premiers signaux de sortie correspondant à des valeurs efficaces ou des valeurs moyennes de courants de phases respectives, et un second signal de sortie correspondant à une valeur de crête maximale des courants des phases respectives,

des premiers moyens de discrimination de niveau (110) qui sont constitués par un micro-ordinateur et qui ont pour but d'effectuer une discrimination portant sur les niveaux du premier signal de sortie des moyens détecteurs de courant (200),

des premiers moyens d'actionnement à caractéristique temps-courant (110) qui sont constitués par un micro-ordinateur et qui sont destinés à émettre un premier signal d'actionnement à caractéristique temps-courant sous la dépendance du signal de sortie des premiers moyens de discrimination de niveau (110),

des premiers moyens de sortie (120), destinés à émettre un signal de détection de surintensité sous la dépendance du signal de sortie des premiers moyens d'actionnement à caractéristique temps-courant (110), caractérisé en ce qu'il comprend en outre:

des seconds moyens de discrimination de niveau (140), destinés à effectuer une opération de discrimination portant sur le niveau du second signal de sortie provenant des moyens détecteurs de courant (200), sans l'aide du micro-ordinateur,

des seconds moyens d'actionnement à caractéristique temps-courant (150), destinés à émettre un second signal d'actionnement à caractéristique temps-courant, sans l'aide du micro-ordinateur, ce signal d'actionnement apparaissant sous l'effet du signal de sortie des seconds moyens de discrimination (140), et

les seconds moyens de discrimination de niveau (140) et les seconds moyens d'actionnement à caractéristique temps-courant (150) étant connectés ensemble d'une manière pratiquement directe, sans traitement de données, et

des seconds moyens de sortie (120′, 121) destinés à émettre un signal de détection de surintensité sous la dépendance du signal de sortie des seconds moyens d'actionnement à caractéristique temps-courant, qui reçoivent conjointement par l'intermédiaire d'un circuit OU les signaux de sortie des premiers et seconds moyens d'actionnement à caractéristiques temps-courant.

2. Un détecteur de surintensité à semiconducteurs selon la revendication 1, comprenant en outre:

des moyens de détection de valeur de crête qui sont incorporés sous la forme d'un étage situé entre les moyens détecteurs de courant (200) et les premiers moyens de discrimination de niveau (110), pour détecter une valeur de crête parmi les signaux de sortie des moyens détecteur de courant (200), et pour émettre un signal de sortie vers les premiers moyens d'actionnement à caractéristique temps-courant (110).

3. Un détecteur de surintensité à semiconducteurs selon la revendication 2, dans lequel les premiers moyens de détection de crête consistent en un circuit OU à diodes (160).

4. Un détecteur de surintensité à semiconducteurs selon la revendication 1, 2 ou 3, dans lequel les moyens détecteurs de courant comprennent des circuits de charge (40) dont une borne est connectée à un point de potentiel commun, et un circuit OU à diodes (130) prévu pour obtenir le second signal de sortie à partir des signaux de sortie des circuits de charge (40).

5. Un détecteur de surintensité à semiconducteurs selon la revendication 1, 2 ou 3, dans lequel

l'un au moins des moyens comprenant les premiers moyens d'actionnement à caractéristique temps-courant (110) et les seconds moyens d'actionnement à caractéristique temps-courant (150) comprend des moyens de démarrage destinés à faire démarrer l'opération temps-courant lorsqu'un signal d'entrée devient supérieur à un niveau prédéterminé, et des moyens de restauration pour restaurer l'opération temps-courant lorsque le signal d'entrée devient inférieur à un niveau prédéterminé.

6. Un détecteur de surintensité à semiconducteur selon la revendication 5, dans lequel

lorsque le signal d'entrée qui est appliqué à l'un au moins des premiers (110) et seconds (150) moyens d'actionnement à caractéristique temps-courant devient inférieur à un niveau prédéterminé, les moyens de restauration accomplissent une restauration en suivant une caractéristique de vitesse de dissipation de chaleur prédéterminée.

7. Un détecteur de surintensité à semiconducteur selon la revendication 1, 2, 3 ou 6, dans lequel

les premiers moyens d'actionnement à caractéristique temps-courant (110) ont une caractéristique dans laquelle le temps varie en fonction inverse du courant.

8. Un détecteur de surintensité à semiconducteurs selon la revendication 1, 2, 3 ou 6, dans lequel les seconds moyens d'actionnement à caractéristique temps-courant (150) ont une caractéristique de réponse instantanée.

9. Un détecteur de surintensité à semiconducteurs selon la revendication 1, 2 ou 3, dans lequel

les moyens détecteurs de courant (200) comportent des moyens (30) destinés à redresser le courant détecté pour donner un courant continu, et ce dernier est utilisé pour fournir l'énergie d'alimentation nécessaire à l'ensemble des circuits du détecteur de surintensité à semiconducteurs.

10. Un détecteur de surintensité à semiconducteurs selon la revendication 1, 2 ou 3, caractérisé en ce que les premiers (120) et seconds (120′) moyens de sortie sont des moyens séparés, grâce à quoi les premiers moyens de sortie (120) reçoivent un signal de sortie des premiers moyens d'actionnement à caractéristique temps-courant (110), et les seconds moyens de sortie (120′) reçoivent un signal de sortie des seconds moyens d'actionnement à caractéristique temps-courant (150).

11. Un disjoncteur comprenant:

des contacts pouvant être ouverts (201, 202, 203), branchés dans des lignes respectives d'un ensemble de lignes de transport d'énergie électrique alternative (10);

un dispositif de déclenchement (80) destiné à provoquer l'ouverture des contacts pouvant être ouverts (201, 202, 203); et

des moyens de commande pour commander le fonctionnement des moyens de déclenchement sous la dépendance d'une condition prédéterminée de surintensité,

les moyens de commande comprenant:

des moyens détecteurs de courant (200) pour des phases respectives des lignes de transport d'énergie électrique alternative (10), destinés à émettre un premier signal de sortie correspondant à des valeurs efficaces ou des valeurs moyennes de courants de phases respectives, et un second signal de sortie correspondant à une valeur de crête maximale des courants de phases respectives,

des premiers moyens de discrimination de niveau (110), constitués par un micro-ordinateur destiné à effectuer une opération de discrimination portant sur les niveaux du premier signal de sortie des moyens détecteurs de courant,

des premiers moyens de déclenchement à caractéristique temps-courant (110), constitués par un micro-ordinateur et destinés à émettre un premier signal de déclenchement à caractéristique temps-courant sous la dépendance du signal de sortie des premiers moyens de discrimination de niveau (110);

des premiers moyens de sortie (120) destinés à émettre un signal de détection de surintensité sous la dépendance du signal de sortie des premiers moyens de déclenchement à caractéristique temps-courant (110), caractérisé en ce qu'il comprend en outre:

des seconds moyens de discrimination de niveau (140) destinés à effectuer une opération de discrimination portant sur le niveau du second signal de sortie des moyens détecteurs de courant (200), sans l'aide du micro-ordinateur,

des seconds moyens de déclenchement à caractéristique temps-courant (150), destinés à émettre un second signal de déclenchement à caractéristique temps-courant sans l'aide du micro-ordinateur, ce signal de déclenchement étant émis sous la dépendance du signal de sortie des seconds moyens de discrimination (140), et

les seconds moyens de discrimination de niveau (140) et les seconds moyens de déclenchement à caractéristique temps-courant (150) étant connectés ensemble d'une manière pratiquement directe, sans traitement de données, et

des seconds moyens de sortie (120', 121) destinés à émettre un signal de détection de surintensité sous la dépendance du signal de sortie des seconds moyens de déclenchement à caractéristique temps-courant, recevant conjointement, par l'intermédiaire d'un circuit OU, les signaux de sortie des premier et second moyens de déclenchement à caractéristique temps-courant.

12. Un disjoncteur selon la revendication 11, comprenant en outre:

des moyens de détection de valeur de crête qui sont incorporés sous la forme d'un étage situé entre les moyens détecteurs de courant (200) et les premiers moyens de discrimination de niveau (110) pour détecter une valeur de crête parmi les signaux de sortie des moyens de détection de courant, et pour émettre un signal de sortie vers les premiers moyens de déclenchement à caractéristique temps-courant.

13. Un disjoncteur selon la revendication 12, dans lequel

les premiers moyens de détection de crête consistent en un circuit OU à diodes (160).

14. Un disjoncteur selon la revendication 11, 12 ou 13, dans lequel

les moyens détecteurs de courant comprennent des circuits de charge (40) dont une borne est connectée à un point de potentiel commun, et un circuit OU à diodes (130), destiné à fournir le second signal de sortie à partir des signaux de sortie des circuits de charge (40).

15. Un disjoncteur selon la revendication 11, 12 ou 13, dans lequel

l'un au moins des premiers moyens de déclenchement à caractéristique temps-courant (110) ou des seconds moyens de déclenchement à caractéristique temps-courant (150) comprend des moyens de démarrage destinés à faire démarrer l'opération temps-courant lorsqu'un signal d'entrée devient supérieur à un niveau prédéterminé, et des moyens de restauration destinés à effectuer une restauration pour l'opération temps-courant lorsque le signal d'entrée devient inférieur à un niveau prédéterminé.

16. Un disjoncteur selon la revendication 15, dans lequel

lorsque le signal d'entrée qui est appliqué à l'un au moins des premiers et seconds moyens d'actionnement à caractéristique temps-courant (150) devient inférieur à un niveau prédéterminé, les moyens de restauration accomplissent une opération de restauration en suivant une caractéristique de vitesse de dissipation de chaleur prédéterminée.

17. Un disjoncteur selon la revendication 12, 13 ou 14, dans lequel

les premiers moyens de déclenchement à caractéristique temps-courant (110) ont une caractéristique dans laquelle le temps varie en fonction inverse du courant.

18. Un disjoncteur selon la revendication 12, 13 ou 14, dans lequel

les seconds moyens de déclenchement à caractéristique temps-courant (150) ont une caractéristique à réponse instantanée.

19. Un disjoncteur selon la revendication 11, 12 ou 13, dans lequel

les moyens détecteurs de courant (200) comportent des moyens (30) pour redresser le courant détecté de façon à donner du courant continu, et pour fournir celui-ci aux moyens de commande en tant qu'énergie d'alimentation.

20. Un disjoncteur selon la revendication 11, 12 ou 13, caractérisé en ce que

les premiers (120) et les seconds (120') moyens de sortie sont des moyens séparés, grâce à quoi les premiers moyens de sortie (120) reçoivent un signal de sortie des premiers moyens de déclenchement à caractéristique temps-courant (110) et les seconds moyens de sortie (120') reçoivent un signal de sortie des seconds moyens de déclenchement à caractéristique temps-courant (150).

# FIG.1 (Prior Art)

EP 0 133 968 B1

FIG.2 (Prior Art)

101 102 103

$I_R$ $I_S$ $I_T$

201 202 203

10

23 22 21

33 32 31

30

43 42 41 40

Burden circuit

90 Mean/effective value circuit

50 Level discrimination circuit

60 Time-current operating circuit

70 Output circuit

80 Output device

801

101' 102' 103'

F I G. 3

Mean value or
effective value

→ Time

F I G. 4

r   s   t   r   s   t   r   s   t

→ Time

FIG.5 (a)

F I G. 5 (b)

F I G. 6

Releasing device — 80
First indicator — 180
Second indicator — 180'
120₁
120₂
Second level discrimination circuit — 140
Second time-current operating circuit — 150
Microcomputer (comprising first level discrimination means + first time-current operation means) — 110
Constant voltage source — 300
A/D converter (with analog multiplexer) — 100
Mean/effective value circuits — 90
93  92  91
Second output signal
Current sensor means
130
133  132  131
Burden circuit — 43
Burden circuit — 42
Burden circuit — 41
40
33  32  31  30
23  22  21
10
200
201 202 203
$I_R$  $I_S$  $I_T$
101 102 103
101' 102' 103'

6

FIG.7

FIG.8

```
        ┌─────────────┐
        │   Start     │────── F1
        └──────┬──────┘
               │
        ┌──────┴──────┐
        │  Initialli- │────── F2
        │   zation    │
        └──────┬──────┘
               │
        ┌──────┴──────┐
        │    A/D      │────── F3
        │ conversion  │
        └──────┬──────┘
               │        1001
               ◇
              Is            NO
          overcurrent ?──────────────┐
               ◇                      │
              YES                     ◇         F5
        ┌──────┴──────┐              Is         NO
        │ Set flag H  │── F4      flag H set ?──────────┐
        └──────┬──────┘              ◇                   │
               │        1002         │                   │
        ┌──────┴──────┐       ┌──────┴──────┐   1003     │
        │ Time-current│       │ Time-current│            │
        │  operation  │       │  operation  │            │
        └──────┬──────┘       │    reset    │            │
               │              └──────┬──────┘            │
               ◇  F6                 │                   │
          NO                         ◇        F8          │
         ┌── Time up ?           Is time-current  NO      │
         │    ◇                  operation entirely ──────┤
         │   YES                 reset ?                   │
         │ ┌──────┴──────┐       ◇                        │
         │ │  Actuate    │ F7   YES                       │
         │ │output device│  ┌──────┴──────┐  F9           │
         │ └──────┬──────┘  │ Reset flag H│               │
         │        │ F10     └──────┬──────┘               │
         │ ┌──────┴──────┐         │                      │
         │ │    End      │         │                      │
         │ └─────────────┘         └──────────────────────┘
```

Heat charging

Heat discharging

# FIG.9

Releasing device 80

Indicator 180

120

Second level discrimination circuit 140

Second time-current operating circuit 150

121

Constant voltage source 300

Microcomputer (comprising first level discrimination means + first time-current operation means) 110

A/D converter 100

160

163 162 161

Second output signal

93 92 91

Mean/effective value circuits 90

130

133 132 131

Burden circuit 43

Burden circuit 42

Burden circuit 41

40

Current sensor means 200

33 32 31

30

23 22 21

10

77

103 102 101

I_T I_S I_R

203 202 201

103' 102' 101'

9

F I G. 10